# EUROPÄISCHE PATENTSCHRIFT

(11) **EP 3 175 521 B1**
(45) Veröffentlichungstag und Bekanntmachung des Hinweises auf die Patenterteilung: **18.09.2019**
(21) Anmeldenummer: 15744871.3
(22) Anmeldetag: 19.06.2015
(51) Int. Cl.: H02B 1/32

(54) **SCHRANKSYSTEM**
CABINET SYSTEM
SYSTÈME D'ARMOIRE

(30) Priorität: 01.08.2014 DE 102014110977; 19.08.2014 DE 102014111806
(43) Veröffentlichungstag der Anmeldung: 07.06.2017
(73) Patentinhaber: Rittal GmbH & Co. KG, 35745 Herborn (DE)
(72) Erfinder: MÜLLER, Matthias, 35683 Dillenburg (DE)
(74) Vertreter: Angerhausen, Christoph
(86) Internationale Anmeldenummer: PCT/DE2015/100246
(87) Internationale Veröffentlichungsnummer: WO 2016/015708

(56) Entgegenhaltungen:
- EP-A1- 1 061 621
- EP-A2- 2 330 703
- WO-A1-2011/041266
- WO-A1-2013/075684
- DE-U1-202004 018 376
- US-A1- 2006 102 575

## Beschreibung

Die Erfindung betrifft ein Schranksystem, mit einem Schrankgehäuse, in das wenigstens eine Komponente für den Innenausbau mit einem Montageabschnitt, der ein erstes Ende und ein davon beabstandetes zweites Ende aufweist, eingebaut und unter Formschluss und unter mechanischer Spannung am Schrankgehäuse gehalten ist, wozu an dem ersten Ende ein Stützabschnitt und an dem zweiten Ende ein Spannabschnitt vorgesehen ist. Ein derartiges Schranksystem ist aus der US 2006/102575 A1 bekannt. Ein ähnliches Schranksystem ist aus der DE 20 2004 018 376 U1 bekannt.

Derartige Schranksysteme sind bekannt, ein Beispiel bildet der Kompakt-Schaltschrank AE der Anmelderin, der im Rittal Handbuch 34, Ausgabe 2014/2015, S. 44 ff., beschrieben ist.

Eine Komponente für den Innenausbau in Gestalt einer Montageschiene ist Gegenstand der WO 2013/075684 A1. Der dort beschriebene Montageabschnitt weist an einem ersten Ende einen Spannabschnitt und an einem zweiten Ende gegenüber dem ersten Ende einen Stützabschnitt auf, wobei der Spannabschnitt einen Kniehebel umfasst. Der Kniehebel hat eine Befestigungsseite, über welche der Kniehebel lösbar mit dem ersten Ende des Montageabschnitts verschraubt ist, weiterhin eine Spannseite, an der die Montageschiene an einer Gehäusewand festgelegt wird. Für eine besonders wirksame Fixierung der Montageschiene an den Innenseiten eines Schrankgehäuses ist vorgesehen, dass sowohl der Stützabschnitt als auch der Spannabschnitt wenigstens eine Kralle aufweist, die sich beim Fixieren in die Innenseiten des Schrankgehäuses gräbt. Ausgehend von diesem Stand der Technik ist es die Aufgabe der Erfindung, ein Schranksystem bereitzustellen, bei dem dynamische Lasten im Innenausbau besser als bisher aufgenommen werden können.

Diese Aufgabe wird von einem Schranksystem nach Anspruch 1 gelöst. Vorteilhafte Ausgestaltungen sind Gegenstand der abhängigen Ansprüche 2 bis 11. Erfindungsgemäß ist vorgesehen, dass an Innenseiten von Wänden, eines Bodens und/oder einer Decke des Schrankgehäuses Einprägungen angebracht sind, die mit zumindest teilweise komplementären Strukturen an wenigstens einem der beabstandeten Enden der Komponente im Eingriff sind, wobei die zumindest teilweise komplementären Strukturen sowohl am Stützabschnitt als auch am Spannabschnitt vorgesehen sind, wobei der Spannabschnitt einen Kniehebel mit einer Befestigungsseite und einer Spannseite umfasst und der Kniehebel an der Befestigungsseite lösbar an dem Montageabschnitt verschraubt ist. Die Einprägungen und die dazu komplementären Strukturen können Belastungen, insbesondere dynamische Lasten, sicher aufnehmen, da die Montageschiene zumindest durch einen Formschluss im Schrankgehäuse gehalten wird. Zudem dienen die Strukturen auch als Positionierhilfe für die Komponenten.

Als Komponente für den Innenausbau werden beispielsweise Montageschienen, Tragschienen, Leuchten oder Steckdosenlisten in Betracht gezogen. Obwohl im Folgenden hauptsächlich auf Montageschienen Bezug genommen wird, versteht es sich, dass die Ausführungen auch für andere Komponenten für den Innenausbau Gültigkeit haben.

Bevorzugt ist, dass die geometrischen Strukturen in einem Raster angebracht sind. Grundsätzlich ist es aber auch möglich, eine andere Positionierung mit unterschiedlichster Beabstandung zu wählen, wie etwa abhängig von der Größe des Schrankgehäuses oder der Größe bzw. den Abmessungen der jeweiligen Komponente. Auch einzelne geometrische Strukturen sind denkbar.

Vorzugsweise weist der Stützabschnitt einen vom Montageabschnitt abgehenden Übergangssteg mit einer davon abgekanteten Befestigungslasche, die im Wesentlichen senkrecht zu den Seiten des Montageabschnitts verläuft, auf, wobei die komplementären Strukturen in der Befestigungslasche angebracht sind.

Am zweiten Ende des Montageabschnitts kann ferner ein Kantenabschnitt vorgesehen sein, auf dem der Kniehebel schwenkbar aufliegt.

Die zumindest teilweise komplementären Strukturen können in der Spannseite des Kniehebels ausgebildet sein.

Die zumindest teilweise komplementären Strukturen können nach einer ersten Ausführungsform der Erfindung Lochungen sein, wobei eine erste Anzahl der Lochungen in der Befestigungslasche des Stützabschnittes und eine zweite Anzahl der Lochungen im Spannabschnitt der Komponente vorgesehen ist. Vorzugsweise stimmt die Anzahl der Lochungen in Stützabschnitt und Spannabschnitt überein. Mit einer solchen Ausgestaltung wird die Komponente für den Innenausbau sowohl durch Kraftschluss als auch durch Formschluss gehalten.

Nach einer zweiten Ausführungsform der Erfindung ist vorgesehen, dass die zumindest teilweise komplementären Strukturen Ausschnitte sind, die zur freien Kante der Befestigungslasche bzw. zur freien Kante einer Umkantung auf der Spannseite des Kniehebels offen sind.

Die Komponente für den Innenausbau des Schranksystems, insbesondere in der Ausgestaltung als Montageschiene oder Tragschiene, kann weiter dadurch gekennzeichnet sein, dass ein erster Abschnitt des Übergangssteges mindestens ein Langloch aufweist, das sich in Längsrichtung des Montageabschnittes erstreckt.

Um vielfältige Einbaumöglichkeiten sicherzustellen, können bei einer Montageschiene oder Tragschiene die Seiten des Montageabschnittes mit einer Systemlochung versehen sein, die in bekannter Weise aus Reihen abwechselnd von kreisförmigen Öffnungen und Langlöchern, die rechteckige Formen haben, bestehen kann.

Aus Stabilitätsgründen ist es vorteilhaft, wenn der Montageabschnitt bei einer Montageschiene oder Tragschiene im Querschnitt U-förmig ist.

Im Folgenden soll die Erfindung anhand der beigefügten Zeichnung näher erläutert werden. Es zeigt:
- Figur 1: eine erste Ausführungsform einer Montageschiene zur Verwendung in einem Schranksystem gemäß der vorliegenden Erfindung;
- Figur 2: eine zweite Ausführungsform einer Montageschiene zur Verwendung in einem Schranksystem gemäß der vorliegenden Erfindung;
- Figur 3: eine perspektivische Detailansicht eines Endes der Montageschiene in einer gegenüber der Figur 2 um 180° gedrehten Position;
- Figur 4: eine Längsschnittansicht der Montageschiene aus Figur 2;
- Figur 5: eine perspektivische Ansicht einer in ein Schrankgehäuse eingebauten Montageschiene nach Figur 2, wobei das Schrankgehäuse nicht Teil der Erfindung ist;
- Figur 6: eine perspektivische Ansicht des Schrankgehäuseinneren, wobei eine Montageschiene gemäß Figur 2 in Kombination mit Chassis verwendet wird;
- Figur 7: eine schematische Darstellung eines Schrankgehäuses, die verschiedene Einbaumöglichkeiten einer Montageschiene zeigt; und
- Figur 8: eine schematische Darstellung eines Schrankgehäuses mit Leuchte und Steckdosenleisten als Komponenten für den Innenausbau.

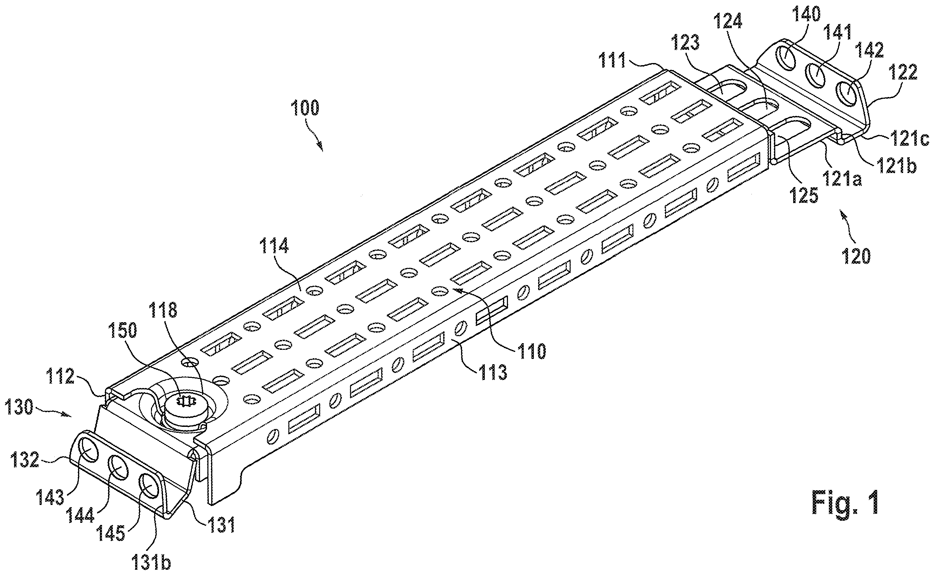

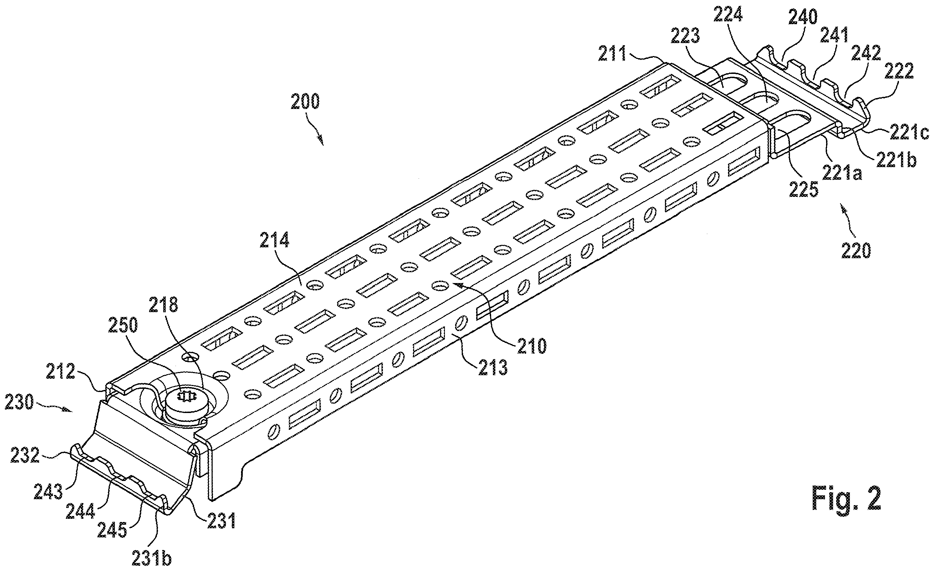

Die Figuren 1 und 2 zeigen jeweils eine perspektivische Darstellung einer Montageschiene 100, 200 gemäß einer ersten und einer zweiten Ausführungsform zur Verwendung in einem Schranksystem gemäß der vorliegenden Erfindung. Die Ausführungsformen entsprechen sich weitgehend, wobei die Unterschiede in der Ausbildung der komplementären Strukturen zu finden sind, wie im Folgenden noch erläutert wird. Insbesondere gelten alle weitergehenden Erläuterungen, die sich auf die Figur 2 beziehen, auch für die Ausführungsform nach Figur 1.

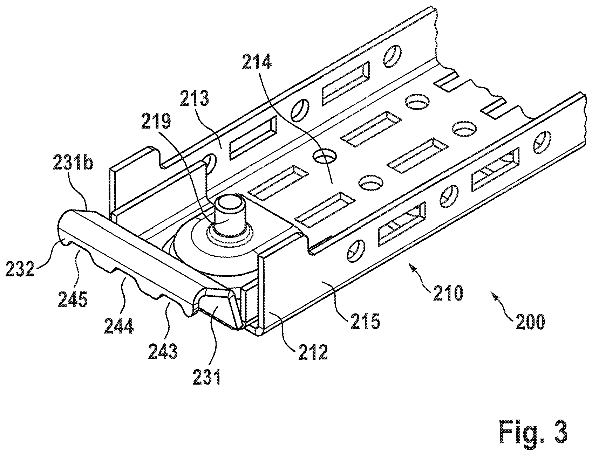

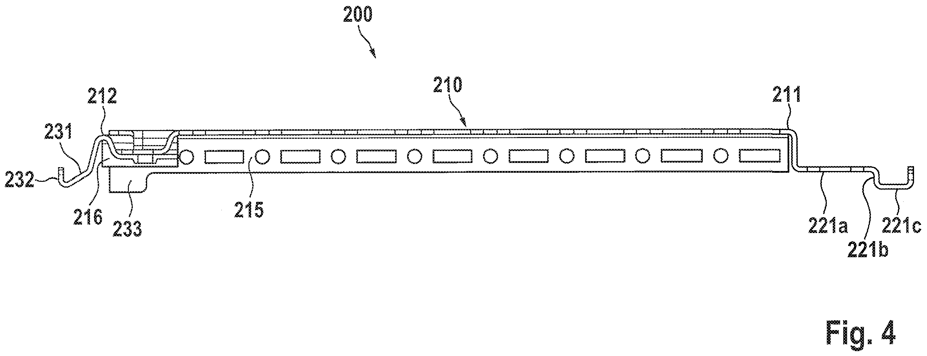

In den Figuren 1 und 2 umfasst eine Montageschiene 100, 200 für ein Schranksystem gemäß der vorliegenden Erfindung einen Montageabschnitt 110, 210 mit einem ersten Ende 111, 211 und einem zweiten Ende 112, 212. Am ersten Ende 111, 211 des Montageabschnitts 110, 210 ist ein Stützabschnitt120, 220 angebracht, der aus einem Übergangssteg 121a, 121b, 121c bzw. 221a, 221b, 221c und einer Befestigungslasche 122, 222 besteht. Dabei verläuft ein erster Abschnitt 121a, 221a senkrecht zu den Seitenwänden 113, 213 (und 215, Figur 3) und parallel zu der Oberseite 114, 214 des Montageabschnitts 110, 210. In diesen Abschnitt 121a, 221a sind drei Langlöcher 123, 124, 125 bzw. 223, 224, 225 eingebracht, die sich parallel zueinander in Längsrichtung des Montageabschnitts 110, 210 erstrecken. An den Abschnitt 121a, 221a schließt sich unter einem rechten Winkel ein Abschnitt 121b, 221b an, der wiederum rechtwinklig in einen Abschnitt 121c, 221c übergeht, der parallel zum Abschnitt 121a, 221a verläuft. Senkrecht zu diesem Abschnitt 121c, 221c schließt sich die Befestigungslasche 122, 222 an, die mit komplementären Strukturen 140, 141, 142 bzw. 240, 241, 242 versehen ist. Der Spannabschnitt 130, 230 am zweiten Ende 112, 212 des Montageabschnitts 110, 210 umfasst einen Kniehebel 131, 231 mit einer Befestigungsseite (besser in Figur 4 zu erkennen) und einer Spannseite 131bm 231b, die eine Umkantung132, 232 aufweist, wobei komplementäre Strukturen 143, 144, 145 bzw. 243, 244, 245 in der Umkantung 132, 232 angebracht sind. Die Befestigungsseite ist mittels einer Schraube 150, 250 lösbar am Montageabschnitt 110, 210 in der Nähe des zweiten Endes 112, 212 angebracht, wobei im Montageabschnitt 110, 210 eine Einsenkung 118, 218 vorgesehen ist, in die der Kopf der Schraube 150, 250 eintaucht, wenn die Schraube 150, 250 angezogen und der Kniehebel somit in einer verriegelnden Position ist.

In der Ausführungsform nach Figur 1 sind die komplementären Strukturen 140, 141, 142 und 143, 144, 145 Öffnungen mit im Wesentlichen kreisrundem Querschnitt, die in die Befestigungslasche 122 bzw. in die Umkantung 132 eingebracht sind. Andere Querschnittsformen, z. B. oval, sind denkbar, die für einen Toleranzausgleich sorgen können. Bei der Ausführungsform nach Figur 2 sind die komplementären Strukturen 240, 241, 242 und 243, 244, 245 etwa halbkreisförmige Ausnehmungen, die zur freien Kante von Befestigungslasche 222 bzw. Umkantung 232 hin offen sind.

Figur 3 zeigt die Montageschiene 200 aus Figur 2 in einer um 180° gedrehten Position im Bereich des zweiten Endes 212. Der Kniehebel 231 ist an seiner Befestigungsseite (siehe Figur 4) mittels einer Schraube am Montageabschnitt 210 festgelegt, wobei am Montageabschnitt 210 eine Gewindehülse 219 angebracht ist, die das Gewinde der Schraube 250 (Figur 2) aufnimmt. Die Befestigungsseite geht über eine mehrfache Umkantung in die Spannseite 231b und insbesondere in die Umkantung 232 über, in der die Ausnehmungen 243, 244, 245 liegen. Im verspannten Zustand des Kniehebels 231 verläuft die Umkantung 232 parallel zu der Befestigungslasche 222 des Stützabschnittes 220 (Figur 2).

Figur 4 zeigt eine Längsschnittansicht der Montageschiene 200 aus Figur 2. Am zweiten Ende 212 des Montageabschnitts 210 ist ein aufragender Kantenabschnitt 216 vorgesehen, der eine Schwenkachse für den Kniehebel 231 definiert. Im gelösten Zustand des Kniehebels 231, wenn also die Schraube 250 (Figur 2) nicht angezogen ist, kann die Umkantung 232 sozusagen zurück verschwenkt werden, so dass sich ein Freiraum zu einer Innenwand eines Schrankgehäuses erzeugen lässt, der für Montagezwecke genutzt werden kann. Der Spannabschnitt 230 ist also, ebenso wie der Ausführungsform nach Figur 1, beweglich, während der Stützabschnitt 220 am gegenüberliegenden ersten Ende 211 des Montageabschnitts 210 starr ist. Man erkennt dort, dass durch den sich an den Abschnitt 221a unter einem rechten Winkel anschließenden Übergangssteg 221b eine Stufe gebildet wird, die an dem zweiten Ende 212 durch einen entsprechenden Vorsprung 233 an der Unterkante der Seite 213 (nicht dargestellt) beziehungsweise 215 ausgeglichen wird.

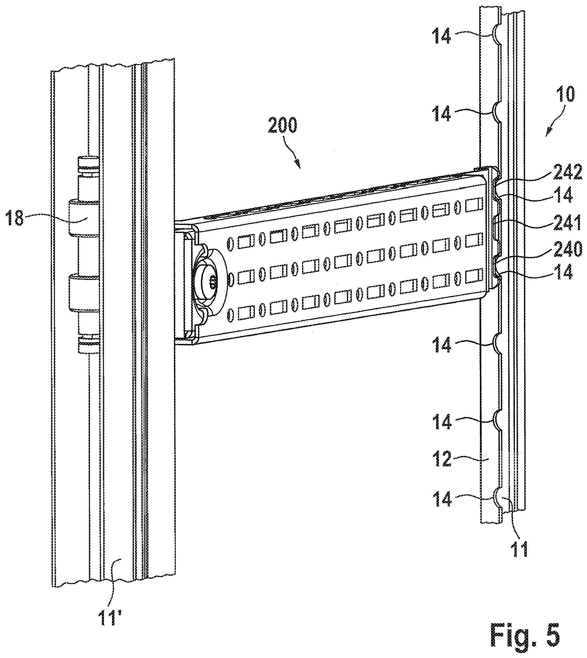

Figur 5 zeigt Ausschnittsweise ein Schrankgehäuse 10, wobei Innenseiten 12 angedeutet sind, die an entsprechenden Seiten des Schrankgehäuses 10 vorgesehen sind. Die Innenseiten 12 weisen eine Anzahl gleich beabstandeter Nocken 14 auf, die also in einem Raster an der Innenseite 12 der Seitenwand vorgesehen sind. Der Seite 12 gegenüberliegend ist eine ähnliche Ausgestaltung vorgesehen, die allerdings in der Zeichnung nicht sichtbar ist. Zwischen den Seitenwänden 11, 11' ist eine Montageschiene 200 montiert, wie sie in den Figuren 2 bis 4 beschrieben ist. Insbesondere werden zwei Nocken 14 von Ausnehmungen 240, 242 umgriffen, während die Ausnehmung 241 unbesetzt bleibt. An der Seitenwand 11' ist die Montageschiene 200 mit Hilfe des Kniehebels 231 (Figuren 2, 3,4) festgelegt. An der Seitenwand 11' ist überdies ein Scharnier 18 angebracht.

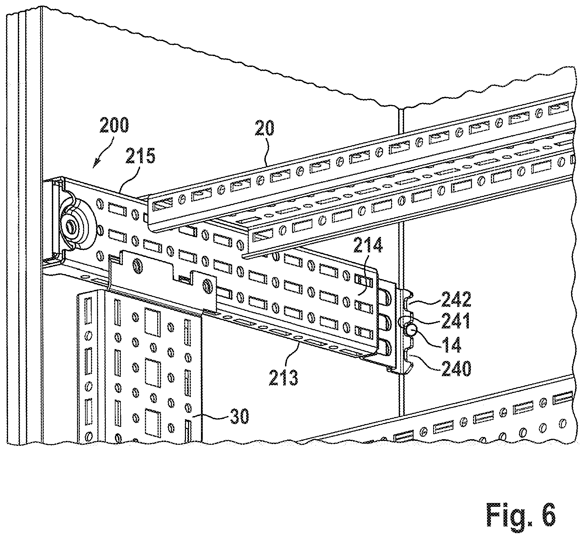

Figur 6 zeigt, wie eine Montageschiene 200 verwendet wird, um weitere Einbauten im Innenraum eines Schrankgehäuses 10 vorzunehmen. Da sämtliche Seiten 213, 214, 215 der Montageschiene beziehungsweise des Montageabschnitts 210 der Montageschiene mit einer Systemlochung versehen sind, ergeben sich vielfältige Anbindemöglichkeiten für Chassis 20, 30. Bei der hier dargestellten Montage wird nur ein Nocken 14 zum Fixieren der Montageschiene 200 vom Stützabschnitt 220 genutzt, während die Ausnehmungen 240, 242 frei bleiben.

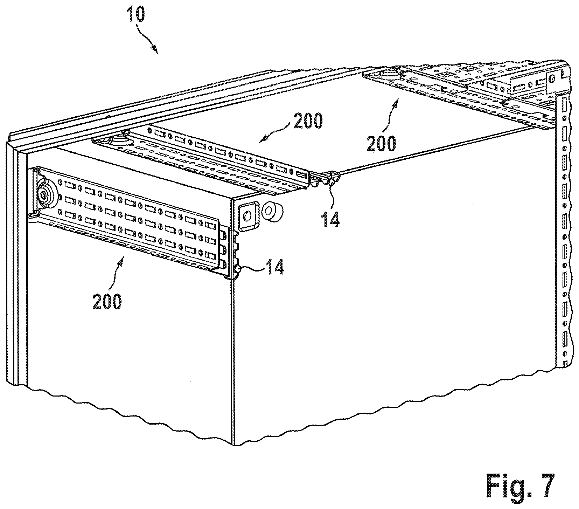

Figur 7 zeigt Varianten für das Anbringen einer Montageschiene 200, einem Schrankgehäuse 10. Die Montageschiene 200 kann nicht nur den Raum zwischen zwei Seitenwänden überspannend angeordnet sein, sondern auch im Deckenbereich, falls erforderlich. Bei beiden der Montagepositionen kann jeweils nur eine der Ausnehmungen einer Montageschiene über einen Nocken gelegt werden.

Durch die Rasterung der Ausnehmungen 240, 241, 242 beziehungsweise 243, 244, 245 und die Rasterung der Nocken 14 geben sich vielfältige Möglichkeiten, die Montageschiene 200 (entsprechendes gilt auch für die Montageschiene 100 gemäß Figur 1) am Schrankgehäuse 10 festzulegen, da nicht notwendigerweise jede Ausnehmung mit einem Nocken oder einer anderen geometrischen Struktur zur Deckung gebracht werden muss, um eine stabile Befestigung der Montageschiene 100 oder 200 am oder im Schrankgehäuse 10 sicherzustellen. Insbesondere kann eine Höhenanpassung oder ein Höhenausgleich stattfinden, der es erlaubt, das Schrankgehäuse mit üblichen Standardbauteilen zu bestücken. Bei einem Rasterabstand von beispielsweise 2,5 cm bei den Öffnungen 140, 141, 142 und 143, 144, 145 bzw. den Ausnehmungen 240, 241, 242 und 243, 244, 245 kann ein Höhenausgleich von bis zu 5 cm stattfinden wenn die Festlegung der jeweiligen Komponente über entsprechend ausgewählte Nocken 14 des Schrankgehäuses 10 vorgenommen wird.

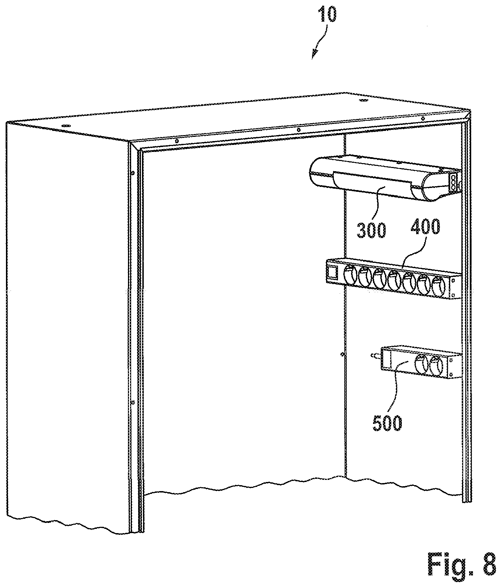

Figur 8 zeigt eine perspektivische Ansicht eines Schrankgehäuses 10, bei dem als Komponenten für den Innenausbau eine Leuchte 300, eine erste Steckdosenleiste 400 und eine zweite Steckdosenleiste 500 in willkürlicher Anordnung angebaut gezeigt sind. Die Leuchte 300 und die erste Steckdosenleiste 400 können mit Stützabschnitten und Spannabschnitten versehen sein, wie sie im Zusammenhang mit den Figuren 1 und 2 für die dort dargestellten Montageschienen 100, 200 beschrieben sind. Auch andere Anbringungsmöglichkeiten sind denkbar, beispielsweise können die eher empfindlichen Leuchten 300 an zu hintergreifenden Vorsprüngen eingehängt werden, so dass die Anbringung nur mit Formschluss, aber ohne oder nur mit geringer mechanischer Spannung erfolgt. Bei der zweiten Steckdosenleiste 500 ist nur eine einseitige Anbringung am Gehäuse vorgesehen, wobei auch hier als geometrische Strukturen zu hintergreifende Vorsprünge zweckmäßig sind.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

## Patentansprüche

1. Schranksystem, mit einem Schrankgehäuse (10), in das wenigstens eine Komponente (100; 200) für den Innenausbau mit einem Montageabschnitt (110, 210), der ein erstes Ende (111, 211) und ein davon beabstandetes zweites Ende (112, 212) aufweist, eingebaut und unter Formschluss und unter mechanischer Spannung am Schrankgehäuse (10) gehalten ist, wozu an dem ersten Ende (111; 211) ein Stützabschnitt (120; 220) und an dem zweiten Ende (112; 222) ein Spannabschnitt (130; 230) vorgesehen ist, **dadurch gekennzeichnet, dass** an Innenseiten von Wänden, eines Bodens und/oder einer Decke des Schrankgehäuses (10) Einprägungen (14) angebracht sind, die mit zumindest teilweise komplementären Strukturen (140, 141, 142, 143, 144, 145; 240, 241, 242, 243, 244, 245) an wenigstens einem der beabstandeten Enden (111, 211; 112, 212) der Komponente (100; 200) im Eingriff sind, wobei die zumindest teilweise komplementären Strukturen (140, 141, 142, 143, 144, 145; 240, 241, 242, 243, 244, 245) sowohl am Stützabschnitt (120; 220) als auch am Spannabschnitt (130; 230) vorgesehen sind, wobei der Spannabschnitt (130, 230) einen Kniehebel (131, 231) mit einer Befestigungsseite und einer Spannseite (131b, 231b) umfasst und der Kniehebel (131, 231) an der Befestigungsseite lösbar an dem Montageabschnitt (110, 210) verschraubt ist.

2. Schranksystem nach Anspruch 1, **dadurch gekennzeichnet, dass** die Komponente für den Innenausbau eine Montageschiene (100; 200), eine Tragschiene, eine Leuchte (300) oder eine Steckdosenleiste (400, 500) ist.

3. Schranksystem nach Anspruch 1, **dadurch gekennzeichnet, dass** die geometrischen Strukturen (14) in einem Raster angebracht sind.

4. Schranksystem nach Anspruch 1, **dadurch gekennzeichnet, dass** der Stützabschnitt (120; 220) einen vom Montageabschnitt (110; 210) abgehenden Übergangssteg (121a, 121b, 121c; 221a, 221b, 221c) mit einer davon abgekanteten Befestigungslasche (122; 222), die im Wesentlichen senkrecht zu den Seiten (113, 114, 115; 213, 214, 215) des Montageabschnitts (110; 210) verläuft, aufweist, wobei die komplementären Strukturen (140, 141, 142; 240, 241, 242) in die Befestigungslasche (122; 222) eingebracht sind.

5. Schranksystem nach Anspruch 1, **dadurch gekennzeichnet, dass** das zweite Ende (112, 212) des Montageabschnitts (110, 210) einen Kantenabschnitt (116, 216) aufweist, auf dem der Kniehebel (131, 231) schwenkbar aufliegt.

6. Schranksystem nach Anspruch 1, **dadurch gekennzeichnet, dass** die zumindest teilweise komplementären Strukturen (143, 144, 145; 243, 244, 245) in der Spannseite (131b, 231b) des Kniehebels (131, 231) ausgebildet sind.

7. Schranksystem nach Anspruch 1, **dadurch gekennzeichnet, dass** die zumindest teilweise komplementären Strukturen (140, 141, 142, 143, 144, 145) Lochungen sind, wobei eine Anzahl (140, 141, 142) der Lochungen im der Befestigungslasche (122) des Stützabschnittes (120) und eine Anzahl (143, 144, 145) der Lochungen im Spannabschnitt (130) der Montageschiene (100) vorgesehen ist.

8. Schranksystem nach Anspruch 1, **dadurch gekennzeichnet, dass** die zumindest teilweise komplementären Strukturen (240, 241, 242, 243, 244, 245) Ausschnitte sind, die zur freien Kante der Befestigungslasche (222) bzw. zur freien Kante einer Umkantung (232) auf der Spannseite (231b) des Kniehebels (231) offen sind.

9. Schranksystem nach Anspruch 4, **dadurch gekennzeichnet, dass** ein erster Abschnitt (121a, 221a) des Übergangssteges (121a, 121b, 121c; 221a, 221b, 221c) mindestens ein Langloch (123, 124, 125; 223, 224, 225) aufweist, das sich in Längsrichtung des Montageabschnittes (210) erstreckt.

10. Schranksystem nach Anspruch 1, **dadurch gekennzeichnet, dass** die Seiten (113, 114; 213, 214) des Montageabschnittes (110; 220) mit einer Systemlochung versehen sind.

11. Schranksystem nach Anspruch 1, **dadurch gekennzeichnet, dass** der Montageabschnitt (110; 210) im Querschnitt U-förmig ist.

## Claims

1. A cabinet system, having a cabinet housing (10) into which at least one component (100; 200) for the interior fittings, having a mounting section (110, 210) that has a first end (111,211) and a second end (112, 212) at a distance from the first, is installed and held on the cabinet housing (10) with a form-fitting connection and under mechanical tension, for which purpose a supporting section (120; 220) is provided at the first end (111; 211) and a tensioning section (130; 230) is provided at the second end (112; 222), **characterized in that** imprints (14) are affixed on the inner sides of walls, of a floor and/or of a ceiling of the cabinet housing (10), which imprints are in engagement with structures (140, 141, 142, 143, 144, 145; 240, 241, 242, 243, 244, 245) that are complementary, at least in part, on at least one of the ends (111, 211; 112, 212) of the component (100; 200) that are spaced apart, wherein the at least partially complementary structures (140, 141, 142, 143, 144, 145; 240, 241, 242, 243, 244, 245) are provided both on the supporting section (120; 220) and on the tensioning section (130; 230), wherein the tensioning section (130, 230) comprises a toggle lever (131, 231) having an attachment side and a tensioning side (131b, 231b), and the toggle lever (131, 231) is releasably screwed onto the mounting section (110, 210) on the attachment side.

2. The cabinet system according to claim 1, **characterized in that** the component for the interior fittings is a mounting rail (100; 200), a support rail, a light (300) or an electrical outlet strip (400, 500).

3. The cabinet system according to claim 1, **characterized in that** the geometrical structures (14) are affixed in a raster.

4. The cabinet system according to claim 1, **characterized in that** the supporting section (120; 220) has a transition crosspiece (121a, 121b, 121c; 221a, 221b, 221c) that proceeds from the mounting section (110; 210) and has an attachment tab (122; 222) that is bent away from the latter and runs essentially perpendicular to the sides (113, 114, 115; 213, 214, 215) of the mounting section (110; 210), wherein the complementary structures (140, 141, 142; 240, 241, 242) are introduced into the attachment tab (122; 222).

5. The cabinet system according to claim 1, **characterized in that** the second end (112, 212) of the mounting section (110, 210) has an edge section (116, 216) on which the toggle lever (131, 231) rests so as to pivot.

6. The cabinet system according to claim 1, **characterized in that** the at least partially complementary structures (143, 144, 145; 243, 244, 245) are configured in the tensioning side (131b, 231b) of the toggle lever (131, 231).

7. The cabinet system according to claim 1, **characterized in that** the at least partially complementary structures (140, 141, 142, 143, 144, 145) are perforations, wherein a number (140, 141, 142) of the perforations is provided in the attachment tab (122) of the supporting section (120), and a number (143, 144, 145) of the perforations is provided in the tensioning section (130) of the mounting rail (100).

8. The cabinet system according to claim 1, **characterized in that** the at least partially complementary structures (240, 241, 242, 243, 244, 245) are cutouts that are open toward the free edge of the attachment tab (222) or toward the free edge of a bent region (232) on the tensioning side (231b) of the toggle lever (231).

9. The cabinet system according to claim 4, **characterized in that** a first section (121a, 221a) of the transition crosspiece (121a, 121b, 121c; 221a, 221b, 221c) has at least one oblong hole (123, 124, 125; 223, 224, 225) that extends in the longitudinal direction of the mounting section (210).

10. The cabinet system according to claim 1, **characterized in that** the sides (113, 114; 213, 214) of the mounting section (110; 220) are provided with a perforation system.

11. The cabinet system according to claim 1, **characterized in that** the mounting section (110; 210) is U-shaped in cross-section.

## Revendications

1. Système d'armoire, avec un boîtier d'armoire (10), dans lequel est inséré et maintenu, par complémentarité de forme et sous contrainte mécanique sur le boîtier d'armoire (10), au moins un composant (100; 200) pour l'aménagement intérieur avec une portion de montage (110, 120), qui comprend une première extrémité (111, 211) et une deuxième extrémité (112, 212) distante de celle-ci, moyennant quoi, pour cela, au niveau de la première extrémité (111 ; 211), une portion d'appui (120; 220) et, au niveau de la deuxième extrémité (112 ; 122), une portion de serrage (130 ; 230) est prévue, **caractérisé en ce que**, au niveau des côtés internes des parois, d'un fond et/ou d'un plafond du boîtier d'armoire (10), sont réalisées des empreintes (14), qui sont emboîtées avec des structures au moins partiellement complémentaires (140, 141, 142, 143, 144, 145; 240, 241, 242, 243, 244, 245), au niveau d'au moins une des extrémités distantes (111, 211; 112, 212) du composant (100 ; 200), les structures au moins partiellement complémentaires (140, 141, 142, 143, 144, 145 ; 240, 241, 242, 243, 244, 245) étant prévues aussi bien sur la portion d'appui (120 ; 220) que sur la portion de serrage (130 ; 230), la portion de serrage (130, 230) comprenant un levier basculant (131, 231) avec un côté de fixation et un côté de serrage (131b, 231b) et le levier basculant (131, 231) est vissé de manière amovible sur la portion de montage (110, 210).

2. Système d'armoire selon la revendication 1, **caractérisé en ce que** le composant pour l'aménagement intérieur est un rail de montage (100 ; 200), un rail porteur, un luminaire (300) ou une barre multiprise (400, 500).

3. Système d'armoire selon la revendication 1, **caractérisé en ce que** les structures géométriques (14) sont réalisées dans une trame.

4. Système d'armoire selon la revendication 1, **caractérisé en ce que** la portion d'appui (120 ; 220) comprend une nervure de transition (121a, 121b, 121c; 221a, 221b, 221c) qui part de la portion de montage (110 ; 210), avec une patte de fixation (122 ; 222) repliée par rapport à celle-ci, qui s'étend globalement de manière perpendiculaire aux côtés (113, 114, 115; 213, 214, 215) de la portion de montage (110; 210), les structures complémentaires (140, 141, 142 ; 240, 241, 242) étant intégrées dans la patte de fixation (122 ; 222).

5. Système d'armoire selon la revendication 1, **caractérisé en ce que** la deuxième extrémité (112, 212) de la portion de montage (110, 210) comprend une portion d'arête (116, 216) sur laquelle s'appuie, de manière pivotante, le levier basculant (131, 231).

6. Système d'armoire selon la revendication 1, **caractérisé en ce que** les structures au moins partiellement complémentaires (143, 144, 145; 243, 244, 245) sont réalisées sur le côté de serrage (131b, 231b) du levier basculant (131, 231).

7. Système d'armoire selon la revendication 1, **caractérisé en ce que** les structures au moins partiellement complémentaires (140, 141, 142, 143, 144, 145) sont des perforations, un nombre (140, 141, 142) des perforations étant prévu dans la patte de fixation (122) de la portion d'appui (120) et un nombre (143, 144, 145) des perforations étant prévu dans la portion de serrage (130) du rail de montage (100).

8. Système d'armoire selon la revendication 1, **caractérisé en ce que** les structures au moins partiellement complémentaires (240, 241, 242, 243, 244, 245) sont des découpes qui sont ouvertes en direction de l'arête libre de la patte de fixation (22) ou vers l'arête libre d'un repli (232) sur le côté de serrage (231b) du levier basculant (231).

9. Système d'armoire selon la revendication 4, **caractérisé en ce qu'**une première portion (121a, 121b) de la nervure de transition (121a, 121b, 121c; 221a, 221b, 221c) comprend au moins un trou oblong (123, 124, 125; 223, 224, 225) qui s'étend dans la direction longitudinale de la portion de montage (210).

10. Système d'armoire selon la revendication 1, **caractérisé en ce que** les côtés (113, 114 ; 213, 214) de la portion de montage (110; 220) sont munis d'une perforation de système.

11. Système d'armoire selon la revendication 1, **caractérisé en ce que** la portion de montage (110 ; 210) présente une section transversale en forme de U.
